# EUROPEAN PATENT APPLICATION

(11) **EP 4 788 112 A2**
(43) Date of publication of application: **05.08.2026**
(21) Application number: 26152256.9
(22) Date of filing: 16.01.2026
(51) Int. Cl.: H10P 72/00, H10P 72/30

(54) **PRINTED CIRCUIT BOARD EDGE HOLD DOWN BELT FOR CLEANER**

(30) Priority: 31.01.2025 US 202519042075
(71) Applicant: Illinois Tool Works Inc., Glenview IL 60025 (US)
(72) Inventor: BECKER, Eric Wayne, Glenview, 60025 (US); CHILTON, Rodney, Glenview, 60025 (US); LAWRENCE, Patrick, Glenview, 60025 (US)
(74) Representative: HGF

(57) **Abstract**

A cleaning apparatus includes cleaning modules configured to treat electronic substrates and a conveyor system configured to transport the electronic substrates through the cleaning modules. The conveyor system includes a bottom belt assembly having a bottom wire mesh belt having first links configured to achieve a first elevation and second links configured to achieve a second elevation. The second elevation are higher than the first elevation. The conveyor system further includes a top belt assembly spaced from the bottom belt assembly. The top belt assembly includes a top wire mesh belt having third links. The bottom belt assembly and the top belt assembly are configured to receive an electronic substrate therebetween to transport the electronic substrate along the conveyor system and through the at least one cleaning module.

## Description

### BACKGROUND OF THE DISCLOSURE

### 1. Field of the Disclosure

This application relates generally to an apparatus for cleaning electronic substrates, including printed circuit boards and semiconductor product assemblies, and, more particularly, to a belt configured to hold electronic substrates in place during a cleaning operation.

### 2. Discussion of Related Art

Various types of liquid cleaning apparatus are used to clean electronic substrates for removal of contaminates, such as flux residues, resins and the like. These contaminates remain on the electronic substrate from the soldering process.

The soldering process has recently advanced in two significant ways - the transition from tin-lead solder to lead-free materials and the reduction in the size of electronic substrate and the associated increase in the density of smaller, low-profile components. These new soldering materials have increased temperature requirements for soldering and are typically formulated to have higher flux content by weight. The combination of lead-free processes and new electronic substrate designs are demanding more time and energy to meet industry cleanliness standards.

Electronic substrates are transported within such cleaning machines by a conveyor, and must be adequately secured during the cleaning process. Stainless steel mesh material belts are used to transport electronic substrate through the cleaning machine. Delicate and sensitive components can be damaged by the stainless steel belt during a cleaning operation.

### SUMMARY OF THE DISCLOSURE

One aspect of the present disclosure is directed to a cleaning apparatus for cleaning electronic substrates including printed circuit boards and semiconductor product assemblies. In one embodiment, the cleaning apparatus comprises at least one cleaning module configured to treat electronic substrates and a conveyor system configured to transport the electronic substrates through the at least one cleaning module. The conveyor system includes a bottom belt assembly having a bottom wire mesh belt having first links configured to achieve a first elevation and second links configured to achieve a second elevation. The second elevation are higher than the first elevation. The conveyor system further includes a top belt assembly spaced from the bottom belt assembly. The top belt assembly includes a top wire mesh belt having third links. The bottom belt assembly and the top belt assembly are configured to receive an electronic substrate therebetween to transport the electronic substrate along the conveyor system and through the at least one cleaning module.

Embodiments of the cleaning apparatus further may include positioning the first links of the bottom wire mesh belt to support a bottom surface of an electronic substrate. The second links of the bottom wire mesh belt may be positioned to engage a lateral edge of the electronic substrate. The third links of the top wire mesh belt may be positioned to engage a top surface of the electronic substrate. The first links and the second links of the bottom wire mesh belt and the third links of the top wire mesh belt may be configured to create a pocket configured to receive an electronic substrate. A width of the pocket may be based on a width of the electronic substrate. The first links and the second links of the bottom wire mesh belt and the third links of the top wire mesh belt are configured to create a first pocket configured to receive a first electronic substrate and a second pocket configured to receive a second electronic substrate. A width of each of the first pocket and the second pocket may be based on a width of the electronic substrate. The first elevation of the first links may be 0.375 inch and the second elevation of the second links may be 0.625 inch. The conveyor system further may include a first outer frame member and a second outer frame member spaced from the first outer frame member. The bottom belt assembly may be disposed between the first outer frame member and the second outer frame member.

Another aspect of the present disclosure is directed to a method for cleaning electronic substrates by the cleaning apparatus. In one embodiment, the method comprises: loading electronic substrates in a carrier device; transporting the carrier device by the conveyor system through the at least one cleaning module; and performing a cleaning operation.

Yet another aspect of the present disclosure are directed to a method of securing an electronic substrate within a conveyor system of a cleaning apparatus. In one embodiment, the method comprises: supporting an electronic substrate with a bottom belt assembly including a bottom wire mesh belt having first links configured to achieve a first elevation and second links configured to achieve a second elevation, the second elevation being higher than the first elevation; and engaging the electronic substrate with a top belt assembly spaced from the bottom belt assembly, the top belt assembly including a top wire mesh belt having third links.

Embodiments of the method further may include positioning the first links of the bottom wire mesh belt to support a bottom surface of the electronic substrate. The second links of the bottom wire mesh belt may be positioned to engage a lateral edge of the electronic substrate. The third links of the top wire mesh belt may be positioned to engage a top surface of the electronic substrate. The first links and the second links of the bottom wire mesh belt and the third links of the top wire mesh belt may be configured to create a pocket configured to receive an electronic substrate. A width of the pocket may be based on a width of the electronic substrate. The first links and the second links of the bottom wire mesh belt and the third links of the top wire mesh belt may be configured to create a first pocket configured to receive a first electronic substrate and a second pocket configured to receive a second electronic substrate. A width of each of the first pocket and the second pocket may be based on a width of the electronic substrate.

### BRIEF DESCRIPTION OF THE DRAWINGS

The accompanying drawings are not intended to be drawn to scale. In the drawings, each identical or nearly identical component that is illustrated in various figures is represented by a like numeral. For purposes of clarity, not every component may be labeled in every drawing. In the drawings:
FIG. 1 is a perspective view of an electronic substrate cleaning apparatus;
FIG. 2 is a perspective view of a portion of a belt conveyor used to transport electronic substrates through the cleaning apparatus;
FIG. 3 is another perspective view of the portion of the belt conveyor; and
FIG. 4 is an end view of a bottom wire mesh belt and a top wire mesh belt of the belt conveyor.

### DETAILED DESCRIPTION OF THE DISCLOSURE

Solder paste is routinely used in the assembly of electronic substrates, including printed circuit boards and semiconductor product assemblies, where the solder paste is used to join electronic components to the substrate. Solder paste includes solder for joint formation and flux for preparing metal surfaces for solder attachment. The solder paste may be deposited onto the metal surfaces (e.g., electronic pads) provided on the electronic substrate by using any number of application methods. In one example, a stencil printer may employ a squeegee to force the solder paste through a metallic stencil laid over an exposed surface of the electronic substrate. In another example, a dispenser may dispense solder paste material onto specific areas of the electronic substrate. Leads of an electronic component are aligned with and impressed into the solder deposits to form the assembly. In reflow soldering processes, the solder is then heated to a temperature sufficient to melt the solder and cooled to permanently couple the electronic component, both electrically and mechanically, to the electronic substrate. The solder typically includes an alloy having a melting temperature lower than that of the metal surfaces to be joined. The temperature also must be sufficiently low so as to not cause damage to the electronic component. In certain embodiments, the solder may be a tin-lead alloy. However, solders employing lead-free materials may also be used. Another process to attach components onto electronic substrates is a wave soldering process.

In the solder, the flux typically includes a vehicle, solvent, activators and other additives. The vehicle is a solid or nonvolatile liquid that coats the surface to be soldered and can include rosin, resins, glycols, polyglycols, polyglycol surfactants, and glycerin. The solvent, which evaporates during the pre-heat and soldering process, serves to dissolve the vehicle activators, and other additives. Examples of typical solvents include alcohols, glycols, glycol esters and/or glycol ethers and water. The activator enhances the removal of metal oxide from the surfaces to be soldered. Common activators include amine hydrochorides, dicarboxylic acids, such as adipic or succinic acid, and organic acids, such as citric, malic or abietic acid. Other flux additives can include surfactants, viscosity modifiers and additives for providing low slump or good tack characteristics for holding the components in place before reflow.

As mentioned above, the soldering processes described herein demand that the electronic substrate be cleaned prior to being released for use. Disclosed herein is an inline cleaning process to remove undesired contaminations from manufacturing processes. In one embodiment, a conveyor system is configured to transport products through a cleaning machine. A conveyor transportation system provides proper retention of electronic substrates or substrate containers during the cleaning process. The conveyor transportation system is configured to properly retain substrates, e.g., printed circuit boards or semiconductor products, in singular form or in tray form, e.g., Jedec tray form. The proper retention eliminates movement or disruption during the cleaning process. The conveyor transportation system can be configured to provide one or more lanes, each providing support and retention to electronic substrates arranged in a linear fashion along the conveyor system.

It is to be appreciated that embodiments of the systems and apparatuses discussed herein are not limited in application to the details of construction and the arrangement of components set forth in the following description or illustrated in the accompanying drawings. The systems and apparatuses are capable of implementation in other embodiments and of being practiced or of being carried out in various ways. Examples of specific implementations are provided herein for illustrative purposes only and are not intended to be limiting. Also, the phraseology and terminology used herein is for the purpose of description and should not be regarded as limiting. The use herein of "including," "comprising," "having," "containing," "involving," and variations thereof is meant to encompass the items listed thereafter and equivalents thereof as well as additional items. References to "or" may be construed as inclusive so that any terms described using "or" may indicate any of a single, more than one, and all of the described terms. Any references to front and back, left and right, top and bottom, upper and lower, and vertical and horizontal are intended for convenience of description, not to limit the present systems and methods or their components to any one positional or spatial orientation.

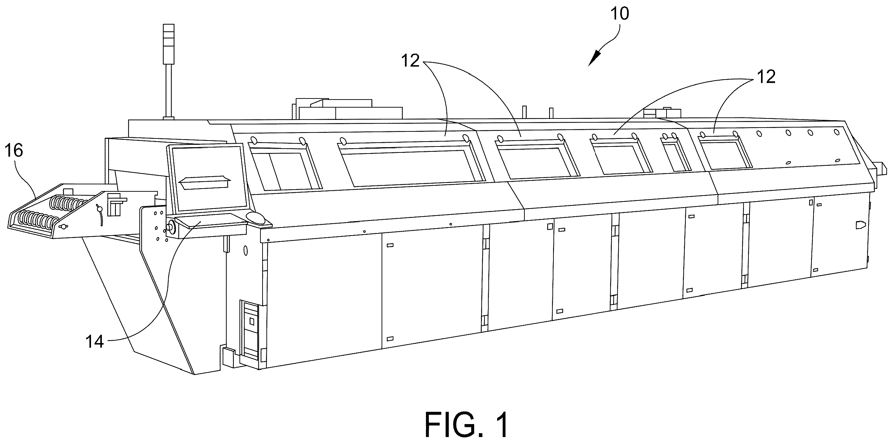

Referring now to the drawings, and more particularly to FIG. 1, an electronic substrate cleaning apparatus is generally indicated at 10. As shown, the cleaning apparatus 10 is an elongate structure that includes several modules, each indicated at 12, to clean and process electronic substrates. In one exemplary embodiment, the cleaning apparatus 10 includes, one or more of the following modules: a pre-wash module, a wash module, a pre-rinse module, a rinse module, and a dry module. A control module having a user interface, together indicated at 14, provides an operator the ability to program and monitor the cleaning apparatus 10.

The cleaning apparatus 10 further includes an elongate conveyor 16 that is configured to transport electronic substrates through the modules 12 of the cleaning apparatus. The conveyor 16 is designed to securely hold electronic substrates during the sometimes rigorous cleaning processes. Embodiments of the present disclosure are directed to improvements in the conveyor 16 and the ability to secure electronic substrates and/or carriers during the cleaning process.

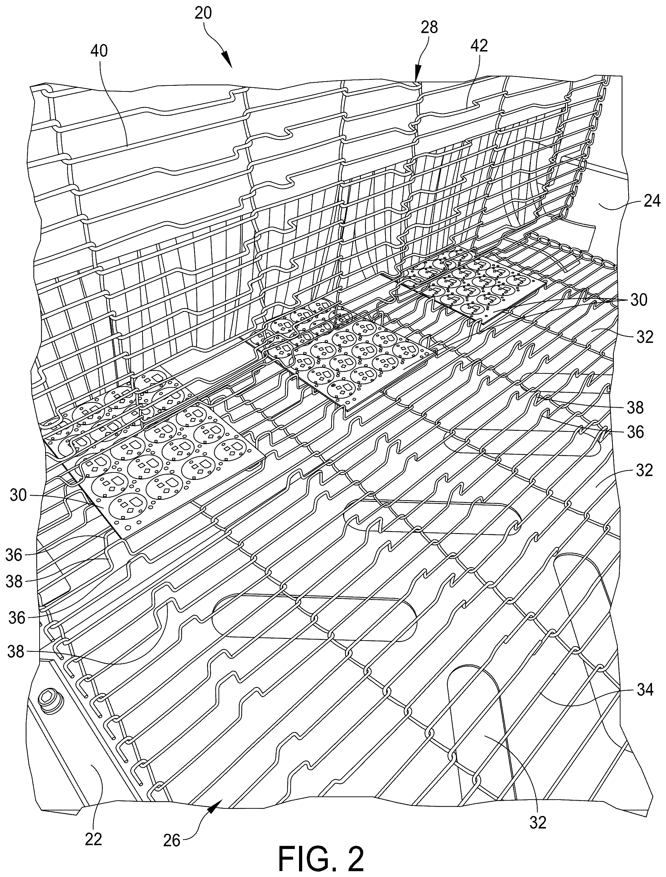

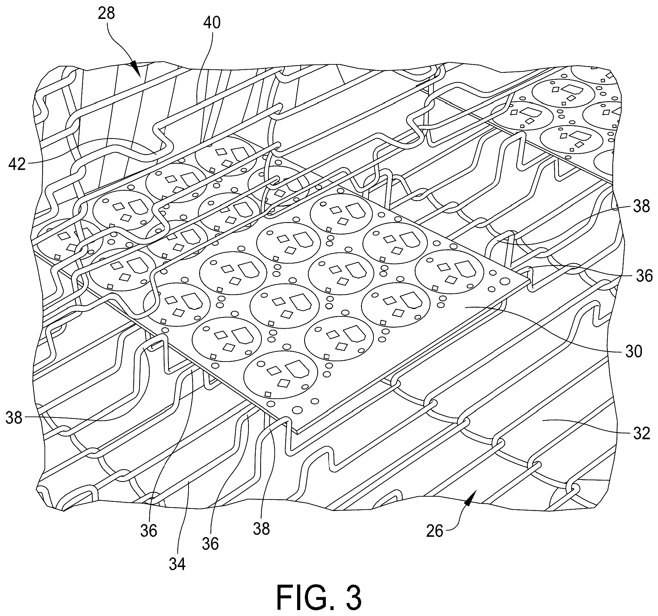

Referring to FIGS. 2 and 3, a portion of a hold down conveyor system of an embodiment of the present disclosure is generally indicated at 20. As shown, the conveyor system 20 includes a first outer frame member 22 and a second outer frame member 24 that are spaced apart and suitably secured within a frame structure provided in the cleaning apparatus 10. The conveyor system 20 further includes a bottom belt assembly, generally indicated at 26, having one or more belts and a top belt assembly, generally indicated at 28, having one or more belts that is spaced from the bottom belt assembly 26. The bottom belt assembly 26 and the top belt assembly 28 are configured to receive an electronic substrate 30 and/or a product carrier therebetween to transport electronic substrates 30 through the modules 12 of the cleaning apparatus 10. As shown, the belt assemblies 26, 28 are disposed between the first outer frame member 22 and the second outer frame member 24 and suitably coupled to the frame members 22, 24 to drive their respective rotations. In one embodiment, a belt drive system can be employed to power the rotations of at least one of the bottom belt assembly 26 and the top belt assembly 28. It should be understood that the rotation of the bottom belt assembly 26, the top belt assembly 28, or both, may be achieved by any type of drive system known in the art.

The top belt assembly 28 is spaced from the bottom belt assembly 26. In one embodiment, as will be described in greater detail below, the bottom belt assembly 26 includes a stainless steel wire belt that can be configured with lanes, each indicated at 32. The lanes 32 are created by forming bends in wires used to create the bottom wire belt of the bottom belt assembly 26. Further, the bottom wire belt of the bottom belt assembly 26 can be configured with any number of lanes 32. For example, the bottom wire belt of the bottom belt assembly 26 can be configured with two, three or four or more lanes 32. The bottom wire belt of the bottom belt assembly 26 is driven by a belt drive system, such as the drive system described above.

Similarly, as will be described in greater detail below, the top belt assembly 28 includes a stainless steel wire belt that is relatively flat across a width of the wire belt. Although not preferred, the top wire belt of the top belt assembly 28 can be configured with one or more lanes that mate with the lanes 32 defined by the bottom wire belt of the bottom belt assembly 28. The top wire belt of the top belt assembly 28 is driven by a belt drive system, such as the drive system described above.

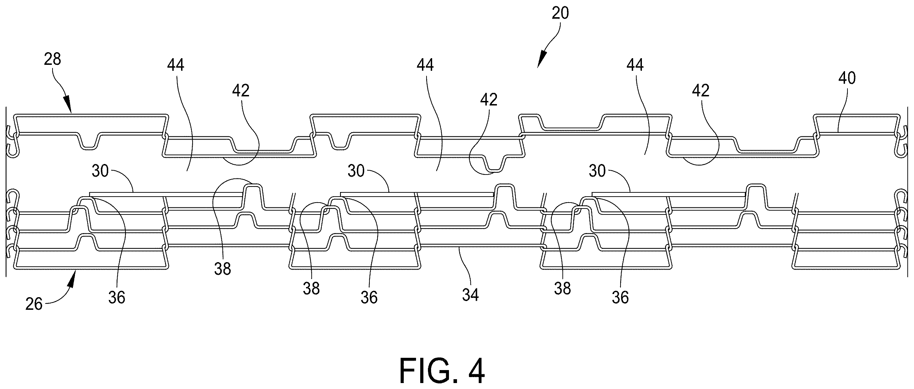

With additional reference to FIG. 4, the top belt assembly 28 is configured to mate with the bottom belt assembly 26 so as to provide spaces created by the three lanes 32, in which electronic substrates 30 and/or carriers can be loaded on the bottom belt assembly 26 without interference from the top belt assembly 28. As shown, the bottom belt assembly 26 includes a bottom wire mesh belt 34 having an intricate network of wires that are interconnected to achieve rows and columns that form the lanes 32 as described above. The bottom wire mesh belt 34 further includes first links, each indicated at 36, formed in the wires along the horizontal rows. The first links 36 are configured to achieve a first elevation with respect to the remaining wires of the bottom wire mesh belt 34. The bottom wire mesh belt 34 further includes second links, each indicated at 38, formed in the wires along the horizontal rows. The second links 38 are configured to achieve a second elevation with respect to the remaining wires of the bottom wire mesh belt 34.

The arrangement is such that the first links 36 and the second links 38 are provided in alternating rows of wires of the bottom wire mesh belt 34, with first links 36 being provided on one row of wires and second links 38 being provided on the next row of wires. In one embodiment, the second elevation of the second links 38 is higher than the first elevation of the first links 36. For example, the first elevation of the first links 36 is 0.375 inch and the second elevation of the second links 38 is 0.625 inch, which is higher than the first links 36.

The top belt assembly 28 includes a top wire mesh belt 40 having an intricate network of wires that are interconnected to achieve a rows and columns, similar to the construction of the bottom wire mesh belt 34. The top wire mesh belt 40 further includes third links, each indicated at 42, that extend below the remaining wires of the top wire mesh belt 34. As shown, the top wire mesh belt 40 of the top belt assembly 28 is spaced from the bottom wire mesh belt 34 of the bottom belt assembly 26. The spaces noted above with respect to the bottom belt assembly 26 and the top belt assembly 28 are configured to receive the electronic substrate 30 and/or the carrier therebetween to transport the electronic substrate 30 along the conveyor system 20 and through the cleaning modules 12 of the cleaning apparatus 10. Specifically, the first links 36 of the bottom wire mesh belt 34 are positioned to support a bottom surface of the electronic substrate 30. The second links 38 of the bottom wire mesh belt 34 are positioned to engage a lateral edge of the electronic substrate 30 to prevent any lateral or side-to-side movement of the electronic substrate 30 when supported. The third links 42 of the top wire mesh belt 40 are positioned to engage a top surface of the electronic substrate 30 to hold the electronic substrate 30 in place during processing.

As used sometimes herein, the spaces formed between the bottom belt assembly 26 and the top belt assembly 28 may be referred to as pockets, each indicated at 44 in FIG. 4, which specifically are formed by the first links 36 and the second links 38 of the bottom wire mesh belt 34 and the third links 42 of the top wire mesh belt 40 to receive the electronic substrate 30. The pockets 44 are provided in the lanes 32 of the bottom belt assembly 26. A width of the pocket 44 is based on a width of the electronic substrate 30. For example, to accommodate the printed circuit board 30 having a width of four inches (4 in.) width, the first links 36 of the bottom wire mesh belt 34 are spaced apart a slightly less distance, e.g., 3.370 in., so that the tops of the first links 36 engage the underside of the printed circuit board 30 to support the printed circuit board 30. Further, to accommodate the same printed circuit board 30, the second links 38 of the bottom wire mesh belt 34 are spaced apart a slightly greater distance, e.g., 4.073 in., so that the second links 38 engage lateral edges of the printed circuit board 30 to prevent lateral or side-to-side movement of the printed circuit board 30. In this position, the third links 42 of the top wire mesh belt 40 engage the top of the printed circuit board 30 to hold the printed circuit board 30 in place during processing.

It should be noted that the bottom wire mesh belt 34 of the bottom belt assembly 26 and the top wire mesh belt 40 of the bottom belt assembly 28 can be configured to transport the electronic substrates 30 and/or the carriers through the cleaning apparatus 10 while protecting the electronic substrates 30 and the carriers. The number and widths of the lanes 32 and the widths and heights of the pockets 44 may be varyied based on the widths of the printed circuit boards 30 being processed by the cleaning apparatus 10. For example, the bottom belt assembly 26 and the top belt assembly 28 of the conveyor system 20 may be configured with any number of lanes, with the links 36, 38 of the bottom wire mesh belt 34 and the link 42 of the top wire mesh belt 40 being configured to accommodate the number of lanes. Further, the widths and heights of the pockets 44 formed by links 36, 38 of the bottom wire mesh belt 34 and the link 42 of the top wire mesh belt 40 may be varied depending on the size of the printed circuit board 30.

Another aspect of the present disclosure is directed to a method of securing the electronic substrate 30 and/or the carrier within the conveyor system 20 of the cleaning apparatus 10. In one embodiment, the method includes supporting the electronic substrate 30 and/or the carrier with the bottom belt assembly 26, which includes the bottom wire mesh belt 34 having the first links 36 configured to achieve a first elevation and the second links 38 configured to achieve a second elevation. The second elevation of the second links 38 is higher than the first elevation of the first links 36. The method further includes engaging the electronic substrate 30 with the top belt assembly 28 spaced from the bottom belt assembly 26. The top belt assembly 28 includes the top wire mesh belt 40 having the third links 42. The first links 36 of the bottom wire mesh belt 34 are positioned to support a bottom surface of the electronic substrate 30. The second links 38 of the bottom wire mesh belt 34 are positioned to engage a lateral edge of the electronic substrate 30. The third links 42 of the top wire mesh belt 40 are positioned to engage a top surface of the electronic substrate 30.

In some embodiments, a method for cleaning electronic substrates 30 with the cleaning apparatus 10 is further provided. In one embodiment, the method of cleaning includes loading electronic substrates 30 and/or the carriers, transporting the electronic substrates 30 and/or the carriers by the conveyor system 20 through the cleaning modules of the cleaning apparatus 10, and performing a cleaning operation. In a certain embodiment, the cleaning operation is controlled by the control module 14 of the cleaning apparatus 10.

It is to be understood that the above description is intended by way of illustration and example only and is not intended to be taken by way of limitation, and that changes and modifications are possible. For example, the cleaning apparatus 10 described above may be any type of cleaning machine that is used to clean electronic substrates. Accordingly, other embodiments are contemplated, and modifications and changes could be made without departing from the scope of this application.

In some embodiments, the control module 14 of the cleaning apparatus 10 may be configured with an operating system, e.g., a Windows^{®}-based operating system, that provides familiar pull-down menus and has data-logging and barcode capability. The operating system is easily networked for downloading of recipes and remote access to operating data. The user interface enables quick and easy viewing of system pressures, water levels, pump and blower operation, temperature, and fill/drain operation.

In some embodiments, the cleaning apparatus 10 may be configured with functional modules 12 that are designed to accomplish different tasks in removing contamination. Some modules maximize flooding, while others maximize impact force for cleaning tight spaces. The cleaning apparatus 10 uses proprietary pump and nozzle technology throughout the system to optimize performance.

In some embodiments, the cleaning apparatus 10 may be configured to have appropriately sized modules and strategic manifold placement increase throughput while ensuring thorough removal of contaminants. The cleaning apparatus 10 may include perforated rails, curtain containment, and a cabinet designed to manage wash solution within the system for maximum conservation of costly chemistries. The cleaning apparatus 10 further may include a wet chemical isolation module that is powered by the recirculating rinse pump to ensure optimal pre-rinsing and to facilitate closed-loop recycling of the rinse section. An exhaust may be separated between the wash and rinse modules to minimize chemical migration through the system.

The cleaning apparatus 10 enables efficient and complete drying during a cleaning process. The cleaning apparatus 10 is configured to increase throughput, providing cost savings and return on investment.

The importance of cleaning electronic assemblies increases dramatically with lead-free soldering. Higher temperatures are required in lead-free soldering, and wetting is much more difficult. To improve "wettability," flux compositions may require higher activation. High-solid flux formulations commonly leave more undesirable residue and require cleaning.

A successful cleaning system must be able to handle the harsh demands of the lead-free process. The cleaning apparatus 10 disclosed herein may be configured with unique cleaning nozzles that provide unmatched impact force to penetrate under and around components and clean even the most challenging flux residues.

Many process parameters may be configured in a computer-controlled operator interface provided in the cleaning apparatus 10. System pressure, water levels, and temperatures are easily accessed. Data logging and barcode capability are features that enhance and streamline the production process.

In some embodiments, the cleaning apparatus 10 may be configured to include nozzles, including "jet" nozzles, to apply a maximum direct dynamic impingement to the product surface and effectively clean under low stand-off components for difficult cleaning applications. The nozzles can be configured to produce large water droplets to enhance the cleaning performance of the cleaning apparatus when operating at a lower rate of pressure. The nozzles can be configured to produce an oscillating action to better clean and flush flux residues in a prewash to reduce foaming in the recirculating wash.

In some embodiments, the cleaning apparatus 10 can be equipped with orbitally welded, stainless steel plumbing to eliminate pressure drops and leaks, all sections can be replaced or upgraded in minutes to maximize uptime and process flexibility. Plumbing sections have quick-disconnect fittings for ease of maintenance.

In some embodiments, the cleaning apparatus 10 can be configured with an optional chemical isolation (CI) module, which is a multi-section module that efficiently removes chemistry from the product prior to the rinse section. The majority of the chemistry is removed in a first section, which is close-looped back into the wash tank reservoir.

In some embodiments, the cleaning apparatus 10 can be configured to include one or more drying modules, which are integrated into a cabinet of the cleaning apparatus. Typical performance includes drying complex assemblies to within 0.1 gram of prewashed dry weight. The module reduces exhaust requirements by 44% and uses 15% less power when compared with conventional drying systems, providing a rapid return on investment.

In some embodiments, the cleaning apparatus 10 can include one or more rear panels, which can be easily removed for maintenance with the added benefit of single door removal to access the wash and rinse tanks. Front doors further can be provided to provide quick access to electrical panels, computer, heaters, floats and thermocouples. The cleaning apparatus 10 can include hinged, tempered glass windows to provide optimum viewing and access.

Having thus described several aspects of at least one embodiment of this disclosure, it is to be appreciated various alterations, modifications, and improvements will readily occur to those skilled in the art. Such alterations, modifications, and improvements are intended to be part of this disclosure, and are intended to be within the spirit and scope of the disclosure. Accordingly, the foregoing description and drawings are by way of example only.

Certain embodiments of the invention are described in the following clauses:
Clause 1. A cleaning apparatus for cleaning electronic substrates including printed circuit boards and semiconductor product assemblies, the cleaning apparatus comprising:
   at least one cleaning module configured to treat electronic substrates; and
   a conveyor system configured to transport the electronic substrates through the at least one cleaning module, the conveyor system including
      a bottom belt assembly including a bottom wire mesh belt having first links configured to achieve a first elevation and second links configured to achieve a second elevation, the second elevation being higher than the first elevation, and
      a top belt assembly spaced from the bottom belt assembly, the top belt assembly including a top wire mesh belt having third links,
      wherein the bottom belt assembly and the top belt assembly are configured to receive an electronic substrate therebetween to transport the electronic substrate along the conveyor system and through the at least one cleaning module.
Clause 2. The cleaning apparatus of clause 1, wherein the first links of the bottom wire mesh belt are positioned to support a bottom surface of an electronic substrate.
Clause 3. The cleaning apparatus of clause 2, wherein the second links of the bottom wire mesh belt are positioned to engage a lateral edge of the electronic substrate.
Clause 4. The cleaning apparatus of clause 3, wherein the third links of the top wire mesh belt are positioned to engage a top surface of the electronic substrate.
Clause 5. The cleaning apparatus of clause 1, wherein the first links and the second links of the bottom wire mesh belt and the third links of the top wire mesh belt are configured to create a pocket configured to receive an electronic substrate.
Clause 6. The cleaning apparatus of clause 5, wherein a width of the pocket is based on a width of the electronic substrate.
Clause 7. The cleaning apparatus of clause 1, wherein the first links and the second links of the bottom wire mesh belt and the third links of the top wire mesh belt are configured to create a first pocket configured to receive a first electronic substrate and a second pocket configured to receive a second electronic substrate.
Clause 8. The cleaning apparatus of clause 7, wherein a width of each of the first pocket and the second pocket are based on a width of the electronic substrate.
Clause 9. The cleaning apparatus of clause 1, wherein the first elevation of the first links is 0.375 inch and the second elevation of the second links is 0.625 inch.
Clause 10. The cleaning apparatus of clause 1, wherein the conveyor system further includes a first outer frame member and a second outer frame member spaced from the first outer frame member.
Clause 11. The cleaning apparatus of clause 10, wherein the bottom belt assembly is disposed between the first outer frame member and the second outer frame member.
Clause 12. A method for cleaning electronic substrates with the cleaning apparatus of clause 1, the method comprising:
   loading electronic substrates in a carrier device;
   transporting the carrier device by the conveyor system through the at least one cleaning module; and
   performing a cleaning operation.
Clause 13. A method of securing an electronic substrate within a conveyor system of a cleaning apparatus, the method comprising:
   supporting an electronic substrate with a bottom belt assembly including a bottom wire mesh belt having first links configured to achieve a first elevation and second links configured to achieve a second elevation, the second elevation being higher than the first elevation; and
   engaging the electronic substrate with a top belt assembly spaced from the bottom belt assembly, the top belt assembly including a top wire mesh belt having third links.
Clause 14. The method of clause 13, wherein the first links of the bottom wire mesh belt are positioned to support a bottom surface of the electronic substrate.
Clause 15. The method of clause 14, wherein the second links of the bottom wire mesh belt are positioned to engage a lateral edge of the electronic substrate.
Clause 16. The method of clause 15, wherein the third links of the top wire mesh belt are positioned to engage a top surface of the electronic substrate.
Clause 17. The method of clause 13, wherein the first links and the second links of the bottom wire mesh belt and the third links of the top wire mesh belt are configured to create a pocket configured to receive an electronic substrate.
Clause 18. The method of clause 17, wherein a width of the pocket is based on a width of the electronic substrate.
Clause 19. The method of clause 13, wherein the first links and the second links of the bottom wire mesh belt and the third links of the top wire mesh belt are configured to create a first pocket configured to receive a first electronic substrate and a second pocket configured to receive a second electronic substrate.
Clause 20. The method of clause 19, wherein a width of each of the first pocket and the second pocket are based on a width of the electronic substrate.

## Claims

1. A cleaning apparatus for cleaning electronic substrates including printed circuit boards and semiconductor product assemblies, the cleaning apparatus comprising:
at least one cleaning module configured to treat electronic substrates; and
a conveyor system configured to transport the electronic substrates through the at least one cleaning module, the conveyor system including
a bottom belt assembly including a bottom wire mesh belt having first links configured to achieve a first elevation and second links configured to achieve a second elevation, the second elevation being higher than the first elevation, and
a top belt assembly spaced from the bottom belt assembly, the top belt assembly including a top wire mesh belt having third links,
wherein the bottom belt assembly and the top belt assembly are configured to receive an electronic substrate therebetween to transport the electronic substrate along the conveyor system and through the at least one cleaning module.

2. The cleaning apparatus of claim 1, wherein the first links of the bottom wire mesh belt are positioned to support a bottom surface of an electronic substrate.

3. The cleaning apparatus of claim 1 or claim 2, wherein the second links of the bottom wire mesh belt are positioned to engage a lateral edge of the electronic substrate.

4. The cleaning apparatus of any one of claims 1 to 3, wherein the third links of the top wire mesh belt are positioned to engage a top surface of the electronic substrate.

5. The cleaning apparatus of any one of claims 1 to 4, wherein the first links and the second links of the bottom wire mesh belt and the third links of the top wire mesh belt are configured to create a pocket configured to receive an electronic substrate, and optionally
wherein a width of the pocket is based on a width of the electronic substrate.

6. The cleaning apparatus of any one of claims 1 to 5, wherein the first links and the second links of the bottom wire mesh belt and the third links of the top wire mesh belt are configured to create a first pocket configured to receive a first electronic substrate and a second pocket configured to receive a second electronic substrate, and optionally
wherein a width of each of the first pocket and the second pocket are based on a width of the electronic substrate.

7. The cleaning apparatus of any one of claims 1 to 6, wherein the first elevation of the first links is 0.375 inch and the second elevation of the second links is 0.625 inch.

8. The cleaning apparatus of any one of claims 1 to 7, wherein the conveyor system further includes a first outer frame member and a second outer frame member spaced from the first outer frame member, and optionally
wherein the bottom belt assembly is disposed between the first outer frame member and the second outer frame member.

9. A method for cleaning electronic substrates with the cleaning apparatus of any one of claims 1 to 8, the method comprising:
loading electronic substrates in a carrier device;
transporting the carrier device by the conveyor system through the at least one cleaning module; and
performing a cleaning operation.

10. A method of securing an electronic substrate within a conveyor system of a cleaning apparatus, the method comprising:
supporting an electronic substrate with a bottom belt assembly including a bottom wire mesh belt having first links configured to achieve a first elevation and second links configured to achieve a second elevation, the second elevation being higher than the first elevation; and
engaging the electronic substrate with a top belt assembly spaced from the bottom belt assembly, the top belt assembly including a top wire mesh belt having third links.

11. The method of claim 10,wherein the first links of the bottom wire mesh belt are positioned to support a bottom surface of the electronic substrate.

12. The method of claim 10 or claim 11, wherein the second links of the bottom wire mesh belt are positioned to engage a lateral edge of the electronic substrate.

13. The method of any one of claims 10 to 12, wherein the third links of the top wire mesh belt are positioned to engage a top surface of the electronic substrate.

14. The method of any one of claims 10 to 13, wherein the first links and the second links of the bottom wire mesh belt and the third links of the top wire mesh belt are configured to create a pocket configured to receive an electronic substrate, and optionally
wherein a width of the pocket is based on a width of the electronic substrate.

15. The method of any one of claims 10 to 14, wherein the first links and the second links of the bottom wire mesh belt and the third links of the top wire mesh belt are configured to create a first pocket configured to receive a first electronic substrate and a second pocket configured to receive a second electronic substrate, and optionally
wherein a width of each of the first pocket and the second pocket are based on a width of the electronic substrate.
